# EUROPEAN PATENT APPLICATION

(11) **EP 4 832 264 A1**
(43) Date of publication of application: **28.10.2026**
(21) Application number: 24928047.0
(22) Date of filing: 09.09.2024
(51) Int. Cl.: H01R 13/6581, H01H 50/02, H01M 50/204, B60R 16/033, H02B 1/46, H02B 1/16

(54) **HOUSING STRUCTURE OF POWER DISTRIBUTION UNIT, POWER DISTRIBUTION UNIT, BATTERY, AND ELECTRICAL DEVICE**

(30) Priority: 05.03.2024 CN 202410251373
(71) Applicant: Contemporary Amperex Technology Co., Limited, Ningde, Fujian 352100 (CN)
(72) Inventor: QIU, Guanda, Ningde, Fujian 352100 (CN); LI, Yuanxin, Ningde, Fujian 352100 (CN); WANG, Chong, Ningde, Fujian 352100 (CN); ZHENG, Chenling, Ningde, Fujian 352100 (CN); JIANG, Yumin, Ningde, Fujian 352100 (CN)
(74) Representative: Ran, Handong
(86) International application number: PCT/CN2024/117676
(87) International publication number: WO 2025/185116

(57) **Abstract**

Disclosed in the present application are a housing structure (100) of a power distribution unit, a power distribution unit (200), a battery (300), and an electrical device (400). The housing structure (100) of the power distribution unit comprises: an insulating housing (110), in which an inner cavity for mounting an electrical component is formed, the insulating housing (110) being provided with a mounting side wall (111); a connector (120), which is mounted on the outer side of the mounting side wall (111) facing away from the inner cavity, the connector (120) being provided with a connection terminal (121) and a shielding layer (122), the shielding layer (122) surrounding the connection terminal (121), and the connection terminal (121) extending into the inner cavity and being electrically connected to the electrical component; a metal plate (130), which is mounted on the outer side of the mounting side wall (111) facing away from the inner cavity, the metal plate (130) being located between the connector (120) and the mounting side wall (111), the metal plate (130) being provided with a mounting through hole (131), the connection terminal (121) passing through the mounting through hole (131), and the shielding layer (122) being electrically connected to the metal plate (130); and a grounding portion (140), a first end (141) of the grounding portion being electrically connected to the metal plate (130), and a second end (142) of the grounding portion being grounded. The present technical solution aims at solving the problem of low assembly efficiency of power distribution units due to complex overall design structures of power distribution units in the related technologies.

## Description

The present application claims priority to Chinese Patent Application No. 202410251373X filed with the China National Intellectual Property Administration on March 5, 2024 and entitled "SHELL STRUCTURE FOR HIGH-VOLTAGE BOX, HIGH-VOLTAGE BOX, BATTERY, AND ELECTRICAL DEVICE", which is incorporated herein by reference in its entirety.

### TECHNICAL FIELD

The present application relates to the field of battery device technologies, in particular, to a shell structure for a high-voltage box, a high-voltage box, a battery, and an electrical device.

### BACKGROUND

With the development of science and technology, new energy electric vehicles have gradually gained popularity. As one of core components of an electric vehicle, a battery is an energy center of the electric vehicle. A high-voltage box, as an energy distribution unit of the battery, plays an irreplaceable role in the overall electric vehicle. In an energy distribution process of the high-voltage box, Electromagnetic Compatibility (EMC) of the high-voltage box is one of its important parameter indexes.

In order that the high-voltage box is capable of meeting EMC requirements, a connector of the high-voltage box needs to be grounded. In related technologies, the connector of the high-voltage box is mounted on an insulating shell of the high-voltage box, which makes it impossible for the connector to be grounded easily and directly. It is necessary to design a matching grounding structure additionally to enable the connector to be grounded. However, the grounding structure designed for matching complicates the overall design structure of the high-voltage box, resulting in a low assembly efficiency of the high-voltage box.

### SUMMARY OF THE INVENTION

An objective of the present application is to provide a shell structure for a high-voltage box, a high-voltage box, a battery, and an electrical device, aiming to solve the problem of low assembly efficiency of the high-voltage box caused by a complicated overall design structure of the high-voltage box in the related technologies.

To achieve the above objective, according to a first aspect of the present application, a technical solution adopted in the present application is: a shell structure for a high-voltage box, including:
an insulating shell provided with an inner cavity for mounting an electrical component, the insulating shell being provided with an assembling sidewall;
a connector mounted on an outer side of the assembling sidewall facing away from the inner cavity, where the connector is provided with a connection terminal and a shielding layer, the shielding layer surrounds the connection terminal, and the connection terminal passes through the assembling sidewall to the inner cavity and is configured to be electrically connected to the electrical component;
a metal plate mounted on the outer side of the assembling sidewall facing away from the inner cavity, where the metal plate is located between the connector and the assembling sidewall, the metal plate is provided with an assembling through hole, the connection terminal passes through the assembling through hole, and the shielding layer is electrically connected to the metal plate; and
a grounding portion, where a first end of the grounding portion is electrically connected to the metal plate and a second end of the grounding portion is configured for grounding.

A high-voltage box is obtained by assembling and formation by applying the shell structure for a high-voltage box designed and provided in the present application. Due to the additionally designed metal plate, both the connector and the metal plate are assembled on the assembling sidewall of the insulating shell, and the metal plate is located between the connector and the assembling sidewall. Therefore, the shielding layer of the connector is capable of being in direct contact with the metal plate, the shielding layer is connected through the metal plate for transition, and grounding is achieved through the grounding portion so that the high-voltage box is capable of meeting EMC requirements. The high-voltage box of the present application has a simple design structure, which greatly improves the assembling efficiency of the high-voltage box.

Furthermore, since the metal plate and the grounding portion are both located on the assembling sidewall of the insulating shell, there is almost no additional protrusion on the assembling sidewall. In other words, the volume of the insulating shell is almost the same as the overall volume of the high-voltage box. Compared with the high-voltage boxes of the related technologies, the high-voltage box of the present application is capable of reducing the overall volume of the high-voltage box, thereby reducing the assembly space required for assembling the high-voltage box.

In some embodiments of the present application, the shielding layer is inserted into the assembling through hole, and the shielding layer is in contact with a hole wall of the assembling through hole, so that the shielding layer is connected outward through the metal plate for transition, thereby enabling grounding to be achieved more easily and directly through the grounding portion.

In some embodiments of the present application, the metal plate is pre-embedded and fixed to the assembling sidewall, thereby directly bonding the metal plate to the insulating shell and improving production efficiency.

In some embodiments of the present application, the metal plate is fixed to the assembling sidewall by a first screw, thereby quickly assembling the metal plate onto the assembling sidewall of the insulating shell and improving assembly efficiency.

In some embodiments of the present application, the metal plate includes a plate body and a connecting portion connected to each other, and the first end of the grounding portion is secured to the connecting portion by a second screw. Alternatively, in some embodiments of the present application, the metal plate includes a plate body and a connecting portion connected to each other, and the first end of the grounding portion is welded to the connecting portion. In this way, the shielding layer is connected through the metal plate and the grounding portion for transition, thereby being capable of achieving grounding simply and quickly.

In some embodiments of the present application, the metal plate and the grounding portion are integrally formed. The integrated metal plate and grounding portion allow for faster assembly and improve the assembly efficiency.

In some embodiments of the present application, the assembling sidewall is provided with a mounting groove, and the metal plate is mounted in the mounting groove. In this way, the metal plate can be quickly positioned by the mounting groove, thus enabling the metal plate to be assembled quickly.

In some embodiments of the present application, a groove depth of the mounting groove is less than or equal to a plate thickness of the metal plate. This allows the shielding layer to be in easy and direct contact with the metal plate to achieve electrical conduction when the connector is locked to the assembling sidewall by a plurality of first screws, facilitating the connection of the grounding portion to the metal plate. In this way, the shielding layer can be connected through the metal plate and the grounding portion for transition, thereby being capable of achieving grounding simply and quickly.

In some embodiments of the present application, the insulating shell is provided with a grounding mounting pin, the second end of the grounding portion extends to the grounding mounting pin, and the second end of the grounding portion is secured to the grounding mounting pin by a screw. The grounding mounting pin provides a positioning mounting position for the second end of the grounding portion, which determines a mounting position of the second end of the grounding portion, and helps improve the assembly efficiency of assembling the high-voltage box to a battery.

According to a second aspect of the present application, a high-voltage box is designed and provided. Specifically, the high-voltage box includes an electrical component and the shell structure for a high-voltage box as described above. The electrical component is mounted in the inner cavity of the insulating shell of the shell structure, and the electrical component is electrically connected to the connection terminal of the connector of the shell structure.

The high-voltage box is obtained by assembling and formation by applying the shell structure for a high-voltage box designed and provided in the present application. Due to the additionally designed metal plate, both the connector and the metal plate are assembled on the assembling sidewall of the insulating shell, and the metal plate is located between the connector and the assembling sidewall. Therefore, the shielding layer of the connector is capable of being in direct contact with the metal plate, the shielding layer is connected through the metal plate for transition, and grounding is achieved through the grounding portion so that the high-voltage box is capable of meeting EMC requirements. The high-voltage box of the present application has a simple design structure, which greatly improves the assembling efficiency of the high-voltage box. Furthermore, compared with the high-voltage boxes of the related technologies, the high-voltage box of the present application is capable of reducing the overall volume of the high-voltage box, thereby reducing the assembly space required for assembling the high-voltage box.

According to a third aspect of the present application, a battery is designed and provided. Specifically, the battery includes the high-voltage box as described above.

In some embodiments of the present application, the battery further includes a metal box shell, the high-voltage box is arranged inside the metal box shell, the insulating shell is provided with a plurality of connecting pins, each of the connecting pins is connected to the metal box shell, and the second end of the grounding portion of the shell structure is arranged to be in contact with the metal box shell. This allows the second end of the grounding portion of the high-voltage box to be grounded through the metal box shell.

In some embodiments of the present application, the connecting pins are secured to the metal box shell by screws; or, the metal box shell is provided with a plurality of locking structures, the plurality of locking structures are arranged in one-to-one correspondence to the connecting pins, and the connecting pins are secured to the metal box shell by the corresponding locking structures. This allows the high-voltage box to be quickly assembled onto the metal box shell, thereby improving the assembly efficiency.

In some embodiments of the present application, the insulating shell is provided with a grounding mounting pin, the grounding mounting pin is secured to the metal box shell by a third screw, and the grounding mounting pin and a side wall of the metal box shell clamp and fix the second end of the grounding portion. The assembling method of securing the grounding mounting pin and the second end of the grounding portion to the metal box shell with the third screw allows the second end of the grounding portion to be quickly mounted onto the metal box shell, which is conducive to improving the assembly efficiency.

According to a fourth aspect of the present application, an electrical device is designed and provided. Specifically, the electrical device includes an electrical load and the battery as described above, and the battery is electrically connected to the electrical load and is configured to supply power.

### DESCRIPTION OF DRAWINGS

To describe the technical solutions in the embodiments of the present application more clearly, the following briefly introduces the accompanying drawings required for describing the embodiments or the prior art. Apparently, the accompanying drawings described in the following are merely some embodiments in the present application, and a person of ordinary skill in the art may still derive other drawings from these accompanying drawings without creative efforts.
FIG. 1 is a schematic structural diagram of a high-voltage box mounted to a metal box shell according to the present application;
FIG. 2 is a partially exploded schematic diagram of the high-voltage box shown in FIG. 1;
FIG. 3 is a schematic structural diagram of another high-voltage box mounted to a metal box shell according to the present application;
FIG. 4 is a partially exploded schematic diagram of the high-voltage box shown in FIG. 3;
FIG. 5 is an exploded schematic diagram of a battery according to an embodiment of the present application; and
FIG. 6 is a schematic structural diagram of an electronic device according to an embodiment of the present application.

### Reference Numerals in the Drawings:

100. Shell structure for high-voltage box;
110. Insulating shell; 111. Assembling sidewall; 112. Mounting groove; 113. Grounding mounting pin; 114. Connecting pin;
120. Connector; 121. Connection terminal; 122. Shielding layer;
130. Metal plate; 131. Assembling through hole; 132. Plate body; 133. Connecting portion;
140. Grounding portion; 141. First end of grounding portion; 142. Second end of grounding portion;
151. First screw; 152. Second screw; 153. Third screw;
200. High-voltage box
300. Battery; 310. Metal box shell; 311. Box body; 312. Box cover; 320. Battery cell;
400. Electrical device; 410. Electrical load; 420. Chassis.

### DETAILED DESCRIPTION

The embodiments of the present application are described in detail below. Examples of the embodiments are illustrated in the accompanying drawings, where the same or similar labels from beginning to end denote the same or similar components or components having the same or similar functions. The embodiments described below with reference to the accompanying drawings are exemplary and are intended to explain the present application, but should not be construed as limiting the present application.

In the descriptions of the present application, it should be understood that orientations or positional relationships indicated by "length", "width", "upper", "lower", "front", "rear", "left", "right", "vertical", "horizontal", "top", "bottom", "inner", "outer", and the like are orientations or positional relationships as shown in the drawings, and are only for the purpose of facilitating and simplifying the descriptions of the present application instead of indicating or implying that apparatuses or elements indicated must have particular orientations, and be constructed and operated in the particular orientations, so that these terms are not construed as limiting the present application.

Moreover, terms such as "first" and "second" are merely used for the purpose of description, and cannot be understood as indicating or implying relative importance or implicitly indicating the number of indicated technical features. Therefore, features limited by "first", "second", and the like may explicitly or implicitly include one or more features. In the description of the present application, the meaning of "a plurality of" is two or more, unless otherwise explicitly and specifically defined.

In the present application, unless otherwise expressly specified and limited, the terms "mount," "connected," "connect" and "fix" should be broadly understood, for example, they may be a fixed connection or a detachable connection or be integrated; or may be a mechanical connection or an electrical connection; or may be a direct connection or an indirect connection through an intermediate medium, or may be a communication between the interior of two elements or the interaction of two elements. For those of ordinary skill in the art, the specific meaning of the above terms in the present application may be understood on a case-by-case basis.

With the continuous improvement in people's material quality of life, the frequency with which they use cars for transportation is gradually increasing, thus driving the continuous development of the automotive industry. The growth and development of new energy electric vehicles has been particularly significant in recent years, covering vehicle types such as family cars for daily commuting, buses for short-distance passenger transport, rail trains for long-distance passenger transport, and light trucks for short-distance freight transport. The development momentum of new energy electric vehicles (hereinafter referred to as electric vehicles, in a narrow sense, electric vehicles refer to family cars for daily commuting) is particularly rapid, and the market share of electric vehicles in the automobile market is increasing year by year.

An electric vehicle is powered by a drive motor, and the drive motor in turn requires a battery to provide necessary electrical energy. In addition, the battery also supplies power to electrical loads on the electric vehicle. A high-voltage box is an energy distribution unit that distributes energy from the battery to electrical loads such as the drive motor, and plays an irreplaceable and important role in the overall electric vehicle. Therefore, it is necessary to strictly control product quality of the high-voltage box. Electromagnetic compatibility of the high-voltage box is one of important parameters for evaluating its product quality.

Electromagnetic compatibility (EMC for short) refers to the ability of a device or system to operate satisfactorily in its electromagnetic environment without causing unacceptable electromagnetic interference to any other device in that environment. Therefore, the EMC includes two aspects of requirements. On the one hand, it means that the electromagnetic interference generated by the device or system during operation must not exceed a certain limit. On the other hand, it means that the device or system has a certain degree of immunity to electromagnetic interference in the environment, namely Electromagnetic Susceptibility (EMS).

In related technologies, the connector of the high-voltage box is mounted on an insulating shell, which makes it impossible for the connector to be grounded easily and directly. It is necessary to design a matching grounding structure additionally to enable the connector to be grounded. However, the grounding structure designed for matching complicates the overall design structure of the high-voltage box, resulting in a low assembly efficiency of the high-voltage box.

Based on the above considerations, embodiments of the present application provide a shell structure for a high-voltage box, and the shell structure is adopted to perform assembling and formation to obtain a high-voltage box, and the high-voltage box is applied to a battery to perform an energy distribution function. Furthermore, the battery is applied to an electrical device, and energy is distributed to an electrical load of the electrical device through the high-voltage box, so as to achieve power supply. The shell structure for a high-voltage box provided by the embodiments of the present application has a simple design structure, which improves assembly efficiency of the high-voltage box and reduces an overall volume of the high-voltage box, thereby reducing assembly space required for assembling the high-voltage box.

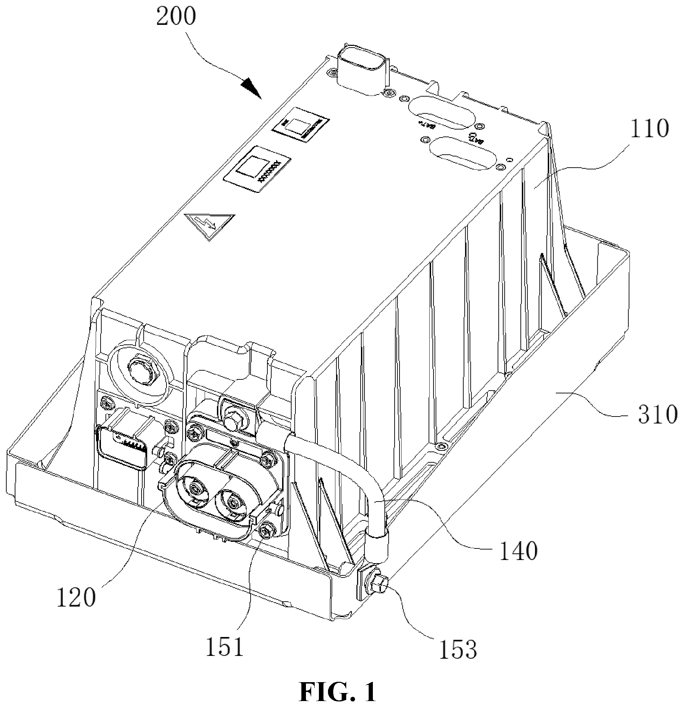

As shown in FIG. 1 to FIG. 4, a shell structure 100 for a high-voltage box provided by the embodiments of the present application includes an insulating shell 110, a connector 120, a metal plate 130, and a grounding portion 140. The grounding portion 140 has a first end and a second end (i.e., a first end 141 of the grounding portion and a second end 142 of the grounding portion). The insulating shell 110 is provided with an inner cavity for mounting an electrical component, and the electrical component is configured to enable the high-voltage box to perform an electrical function of energy distribution. The insulating shell 110 is provided with an assembling sidewall 111, and the connector 120 is mounted on an outer side of the assembling sidewall 111 facing away from the inner cavity. The connector 120 is provided with a connection terminal 121 and a shielding layer 122. The shielding layer 122 surrounds the connection terminal 121, and the shielding layer 122 and the connection terminal 121 are mutually insulated by an insulating layer. The connection terminal 121 passes through the assembling sidewall 111 to the inner cavity and is configured to be electrically connected to the electrical component. The metal plate 130 is mounted on the outer side of the assembling sidewall 111 facing away from the inner cavity of the insulating shell 110, where the metal plate 130 is located between the connector 120 and the assembling sidewall 111, the metal plate 130 is provided with an assembling through hole 131, the connection terminal 121 passes through the assembling through hole 131, and the shielding layer 122 is electrically connected to the metal plate 130. The first end 141 of the grounding portion is electrically connected to the metal plate 130 and the second end 142 of the grounding portion is configured for grounding.

A high-voltage box 200 is obtained by assembling and formation by applying the shell structure 100 for a high-voltage box designed and provided in the present application. Due to the additionally designed metal plate 130, both the connector 120 and the metal plate 130 are assembled on the assembling sidewall 111 of the insulating shell 110, and the metal plate 130 is located between the connector 120 and the assembling sidewall 111. Therefore, the shielding layer 122 of the connector 120 is capable of being in direct contact with the metal plate 130, the shielding layer 122 is connected through the metal plate 130 for transition, and grounding is achieved through the grounding portion 140 so that the high-voltage box 200 is capable of meeting EMC requirements. The high-voltage box 200 of the present application has a simple design structure, which greatly improves the assembling efficiency of the high-voltage box 200.

Furthermore, since the metal plate 130 and the grounding portion 140 are both located on the assembling sidewall 111 of the insulating shell 110, there is almost no additional protrusion on the assembling sidewall 111. In other words, the volume of the insulating shell 110 is almost the same as the overall volume of the high-voltage box 200. Compared with the high-voltage boxes of related technologies, the high-voltage box 200 of the present application is capable of reducing the overall volume of the high-voltage box 200, thereby reducing the assembly space required for assembling the high-voltage box 200.

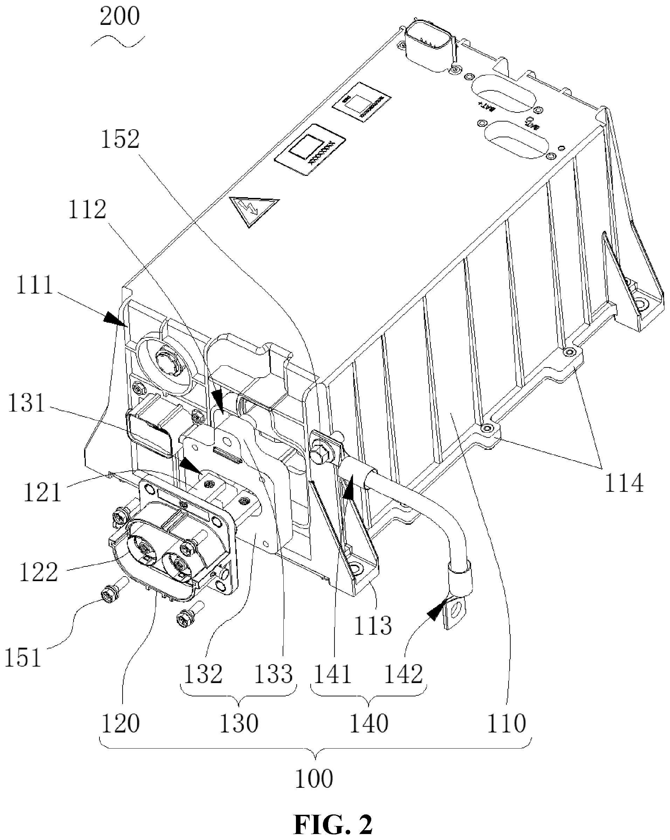

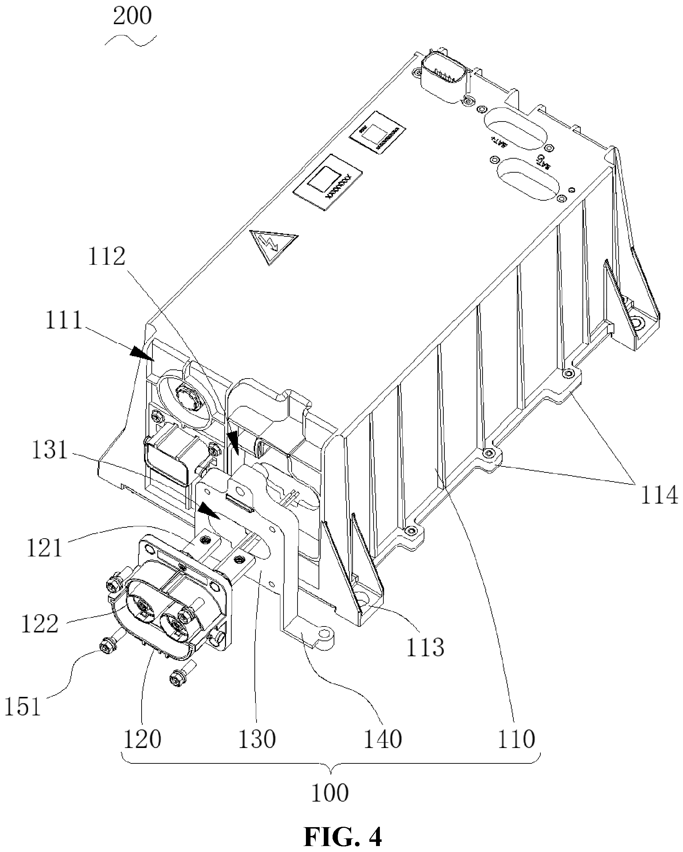

As shown in FIG. 2 and FIG. 4, in some embodiments of the present application, the shielding layer 122 is inserted into the assembling through hole 131, and the shielding layer 122 is in contact with a hole wall of the assembling through hole 131, thereby enabling the shielding layer 122 to conduct with the metal plate 130. When assembling the connector 120 and the metal plate 130 onto the assembling sidewall 111 of the insulating shell 110, it is only necessary to simply stack the metal plate 130 and the connector 120 sequentially on the assembling sidewall 111, align the shielding layer 122 and insert it into the assembling through hole 131, and fix both the connector 120 and the metal plate 130 onto the assembling sidewall 111. In this way, the shielding layer 122 is squeezed by the hole wall of the assembling through hole 131, thereby achieving good contact between the shielding layer 122 and the hole wall of the assembling through hole 131 to achieve electrical conduction. In other words, conduction is established between the shielding layer 122 and the metal plate 130, so that the shielding layer 122 is connected outward through the metal plate 130 for transition, and grounding can be achieved more easily and directly through the grounding portion 140.

In some other embodiments of the present application, an end portion of the shielding layer 122 facing the inner cavity of the insulating shell 110 abuts against a plate surface of the metal plate 130, thereby achieving the conduction between the shielding layer 122 and the metal plate 130. When assembling the connector 120 and the metal plate 130 onto the assembling sidewall 111 of the insulating shell 110, it is only necessary to simply stack the metal plate 130 and the connector 120 sequentially on the assembling sidewall 111, directly abut the end portion of the shielding layer 122 against the plate surface of the metal plate 130, and fix both the connector 120 and the metal plate 130 onto the assembling sidewall 111. In this way, the shielding layer 122 is in good contact with the plate surface of the metal plate 130 to achieve conduction. In this way, conduction is established between the shielding layer 122 and the metal plate 130, so that the shielding layer 122 is connected outward through the metal plate 130 for transition, and grounding can be achieved more easily and directly through the grounding portion 140.

In some embodiments of the present application, the metal plate 130 is pre-embedded and fixed to the assembling sidewall 111, thereby directly bonding the metal plate 130 to the insulating shell 110 and improving the production efficiency. The insulating shell 110 is manufactured using injection molding. During the injection molding, the metal plate 130 is fixed on an injection mold, and molten liquid plastic is poured in. After cooling and solidification, an integral insulating shell 110 and metal plate 130 are obtained. In the integrated insulating shell 110 and metal plate 130, a side surface of the metal plate 130 facing away from the inner cavity of the insulating shell 110 is exposed on the assembling sidewall 111. This allows the shielding layer 122 to be in easy and direct contact with the metal plate 130 to achieve electrical conduction when the connector 120 is locked to the assembling sidewall 111 by a plurality of first screws 151, thereby facilitating the connection of the grounding portion 140 to the metal plate 130. In this way, the shielding layer 122 is capable of being connected through the metal plate 130 and the grounding portion 140 for transition, thereby being capable of achieving grounding simply and quickly.

As shown in FIG. 1 to FIG. 4, in some embodiments of the present application, the metal plate 130 is fixed to the assembling sidewall 111 by the first screws 151, thereby quickly assembling the metal plate 130 onto the assembling sidewall 111 of the insulating shell 110 and improving the assembly efficiency. The insulating shell 110 is manufactured using injection molding. After the insulating shell 110 is obtained by injection molding, the metal plate 130 and the connector 120 are sequentially stacked on the assembling sidewall 111 of the insulating shell 110. Then, the metal plate 130 and the connector 120 are simultaneously locked to the assembling sidewall 111 by the plurality of first screws 151. That is, the first screws 151 pass through the connector 120 and the metal plate 130 in sequence and are screwed and fixed to the assembling sidewall 111, thereby clamping and fixing the connector 120 and the metal plate 130 to the assembling sidewall 111. After the first screws 151 fixedly mount the connector 120 and the metal plate 130 to the assembling sidewall 111, the shielding layer 122 of the connector 120 is in contact with the metal plate 130 to achieve electrical conduction. The shielding layer 122 is connected through the metal plate 130 and the grounding portion 140 for transition, so that grounding can be achieved easily and quickly.

In some embodiments of the present application, as shown in FIG. 2, the metal plate 130 includes a plate body 132 and a connecting portion 133 connected to each other, where the connecting portion 133 is arranged on one side edge of the plate body 132. In this embodiment, the metal plate 130 and the grounding portion 140 are two independent components. The first end 141 of the grounding portion is secured to the connecting portion 133 by a second screw 152, thereby achieving electrical conduction between the grounding portion 140 and the metal plate 130. In this way, the shielding layer 122 is connected through the metal plate 130 and the grounding portion 140 for transition, thereby being capable of achieving grounding simply and quickly.

In some other embodiments of the present application, as shown in FIG. 2, the metal plate 130 includes a plate body 132 and a connecting portion 133 connected to each other, where the connecting portion 133 is arranged on one side edge of the plate body 132. In this embodiment, the metal plate 130 and the grounding portion 140 are two independent components. The first end 141 of the grounding portion is welded to the connecting portion 133, thereby achieving electrical conduction between the grounding portion 140 and the metal plate 130. In this way, the shielding layer 122 is connected through the metal plate 130 and the grounding portion 140 for transition, thereby being capable of achieving grounding simply and quickly.

In some embodiments of the present application, the plate body 132 is square in shape, the connecting portion 133 is located on an upper edge of the plate body 132, and the assembling through hole 131 is opened in a middle region of the plate body 132.

As shown in FIG. 4, in some embodiments of the present application, the metal plate 130 and the grounding portion 140 are integrally formed. In this embodiment, an integral metal plate 130 and grounding portion 140 are obtained by punching on a metal blank through a punching process. Compared to the embodiment described above where the metal plate 130 and the grounding portion 140 are two independent components, in this embodiment, as long as the metal plate 130 is mounted onto the assembling sidewall 111, assembling of the grounding portion 140 is also completed simultaneously. Therefore, the integrated metal plate 130 and grounding portion 140 is capable of completing assembling more quickly, thereby improving the assembly efficiency.

As shown in FIG. 2 and FIG. 4, in some embodiments of the present application, the assembling sidewall 111 is provided with a mounting groove 112, and the mounting groove 112 is directly injection molded through the injection mold when the insulating shell 110 is injection molded. Furthermore, the metal plate 130 is mounted in the mounting groove 112, and the metal plate 130 located in the mounting groove 112 no longer changes its relative position with respect to the assembling sidewall 111. In this way, the metal plate 130 can be quickly positioned by the mounting groove 112, thus enabling the metal plate 130 to be assembled quickly.

In some embodiments of the present application, a groove depth of the mounting groove 112 is less than a plate thickness of the metal plate 130. In this way, after the metal plate 130 is mounted in the mounting groove 112, a side surface of the metal plate 130 facing away from the inner cavity of the insulating shell 110 is exposed on the assembling sidewall 111. This allows the shielding layer 122 to be in easy and direct contact with the metal plate 130 to achieve electrical conduction when the connector 120 is locked to the assembling sidewall 111 by a plurality of first screws 151, thereby facilitating the connection of the grounding portion 140 to the metal plate 130. In this way, the shielding layer 122 is capable of being connected through the metal plate 130 and the grounding portion 140 for transition, thereby being capable of achieving grounding simply and quickly.

In some other embodiments of the present application, the groove depth of the mounting groove 112 is equal to the plate thickness of the metal plate 130. In this way, after the metal plate 130 is mounted in the mounting groove 112, a side surface of the metal plate 130 facing away from the inner cavity of the insulating shell 110 is exposed on the assembling sidewall 111. This allows the shielding layer 122 to be in easy and direct contact with the metal plate 130 to achieve electrical conduction when the connector 120 is locked to the assembling sidewall 111 by a plurality of first screws 151, thereby facilitating the connection of the grounding portion 140 to the metal plate 130. In this way, the shielding layer 122 is capable of being connected through the metal plate 130 and the grounding portion 140 for transition, thereby being capable of achieving grounding simply and quickly.

As shown in FIG. 1 to FIG. 4, in some embodiments of the present application, the insulating shell 110 is provided with a grounding mounting pin 113, the second end 142 of the grounding portion extends to the grounding mounting pin 113, and the second end 142 of the grounding portion is secured to the grounding mounting pin 113 by a third screw 153. The grounding mounting pin 113 provides a positioning mounting position for the second end 142 of the grounding portion, which determines a mounting position of the second end 142 of the grounding portion, and helps improve the assembly efficiency of assembling the high-voltage box 200 to a battery 300.

According to a second aspect of the present application, a high-voltage box 200 is designed and provided. In this embodiment, the high-voltage box 200 includes electrical components (not shown, the electrical components including but not limited to an electromagnetic relay switch, a capacitor, an inductor, a diode, a transistors, and the like, which are connected by connecting harnesses according to a designed circuit to realize the energy distribution function of the high-voltage box 200) and the shell structure 100 for a high-voltage box as described above. The electrical components are mounted in the inner cavity of the insulating shell 110 of the shell structure 100 for a high-voltage box, and the electrical components are electrically connected to the connection terminal 121 of the connector 120 of the shell structure 100 for a high-voltage box.

The high-voltage box 200 is obtained by assembling and formation by applying the shell structure 100 for a high-voltage box designed and provided in the present application. Due to the additionally designed metal plate 130, both the connector 120 and the metal plate 130 are assembled on the assembling sidewall 111 of the insulating shell 110, and the metal plate 130 is located between the connector 120 and the assembling sidewall 111. Therefore, the shielding layer 122 of the connector 120 is capable of being in direct contact with the metal plate 130, the shielding layer 122 is connected through the metal plate 130 for transition, and grounding is achieved through the grounding portion 140 so that the high-voltage box 200 is capable of meeting EMC requirements. The high-voltage box 200 of the present application has a simple design structure, which greatly improves the assembling efficiency of the high-voltage box 200. Furthermore, compared with the high-voltage boxes of related technologies, the high-voltage box 200 of the present application is capable of reducing the overall volume of the high-voltage box 200, thereby reducing the assembly space required for assembling the high-voltage box 200.

According to a third aspect of the present application, a battery 300 is designed and provided, the battery 300 serves as an energy storage device and is configured to store electrical energy, and the battery 300 is applied to an electrical device 400 for power supply. Furthermore, the battery 300 designed and provided in the embodiments of the present application is a lithium battery capable of performing a plurality of charge-discharge cycles, and is widely applied in energy storage power systems of various power plants (including but not limited to energy storage power systems of hydropower, thermal power, wind power, and solar power plants), uninterruptible power supplies for postal and telecommunications, portable electrical appliances (including but not limited to laptops, cameras, mobile communication terminals, power tools, and the like), electric bicycles, electric motorcycles, electric cars, military equipment, aerospace equipment, and the like. In this embodiment, the battery 300 includes the high-voltage box 200 as described above. The high-voltage box 200 distributes energy to the electrical load in the electrical device, allowing the electrical load to operate normally.

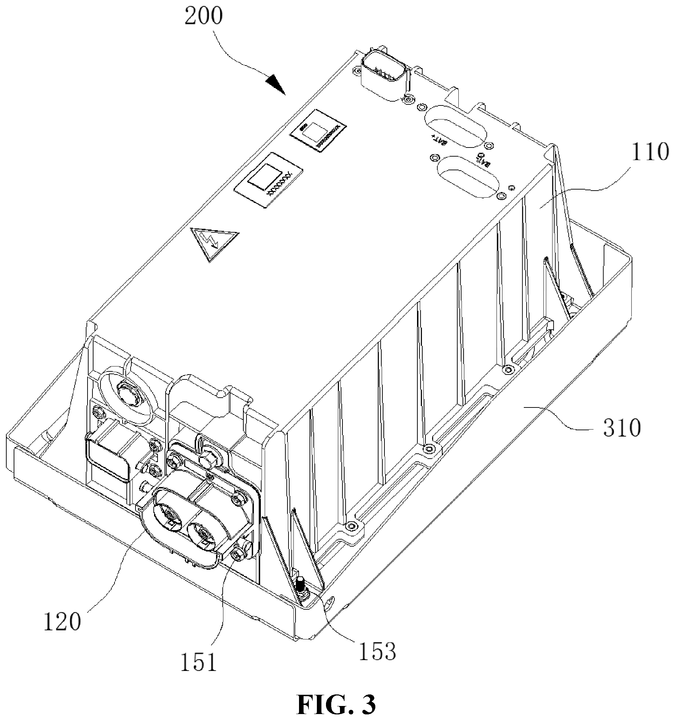

In some embodiments of the present application, the battery 300 further includes a metal box shell 310, as shown in FIG. 1 and FIG. 3. Generally, the metal box shell 310 of the battery 300 must be grounded to achieve grounding protection for the battery 300 itself. The high-voltage box 200 is arranged inside the metal box shell 310. The insulating shell 110 is provided with a plurality of connecting pins 114, as shown in FIG. 2 and FIG. 4. Each of the connecting pins 114 is connected to the metal box shell 310. Furthermore, the second end 142 of the grounding portion of the shell structure 100 for a high-voltage box is arranged in contact with the metal box shell 310. In this way, the second end 142 of the grounding portion is grounded through the metal box shell 310.

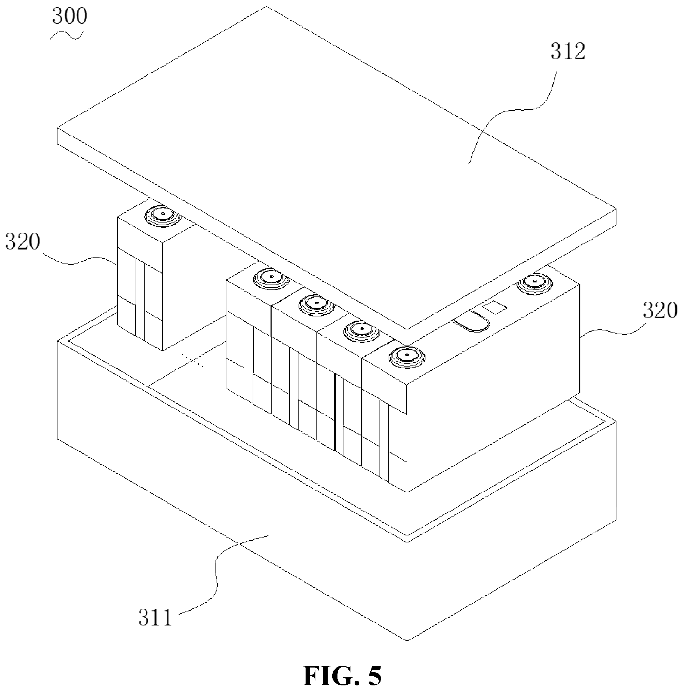

As shown in FIG. 5, the battery 300 of the present application further includes a plurality of battery cells 320, and the plurality of battery cells 320 are mounted in a rectangular array in a mounting cavity of the metal box shell 310. In this embodiment, the metal box shell 310 includes a box body 311 and a box cover 312, where the box cover 312 covers the box body 311 to form the mounting cavity. First, the plurality of battery cells 320 are sequentially placed into the box body 311 to form an array arrangement. The plurality of battery cells 320 are assembled and connected by connecting harnesses using at least one of the following connection methods: series connection, parallel connection, and parallel-series connection. This ensures that the battery 300 formed by the assembling meets a preset rated output voltage and rated output power. The high-voltage box 200 is mounted and fixed inside the box body 311, so that the second end 142 of the grounding portion is in contact with an inner sidewall of the box body 311. Finally, the box cover 312 covers the box body 311 to seal the plurality of battery cells 320 and the high-voltage box 200.

During the operation of the battery 300, the metal box shell 310 encloses the battery cells 320, the high-voltage box 200, a circuit board, and other electrical components, and the metal box shell 310 is then grounded. Therefore, the metal box shell 310 is not only capable of shielding the external electromagnetic interference to the electrical components inside the battery 300, but also capable of shielding electromagnetic waves generated by the electrical components inside the battery 300, thereby reducing the electromagnetic interference caused by the electrical components inside the battery 300 to an electrical device outside the battery 300, and enabling the battery 300 to meet the electromagnetic compatibility requirements.

In some embodiments of the present application, various connecting pins 114 of the insulating shell 110 are secured to the metal box shell 310 by screws, so that the high-voltage box 200 can be quickly assembled onto the metal box shell 310, thereby improving the assembly efficiency.

In some other embodiments of the present application, the metal box shell 310 is provided with a plurality of locking structures (not shown), and the plurality of locking structures are arranged in one-to-one correspondence with the connecting pins 114. The connecting pins 114 of the insulating shell 110 are secured to the metal box shell 310 by the corresponding locking structures. This allows the high-voltage box 200 to be quickly assembled onto the metal box shell 310, thereby improving the assembly efficiency.

In some embodiments of the present application, the insulating shell 110 is provided with a grounding mounting pin 113, as shown in FIG. 2 and FIG. 4. The grounding mounting pin 113 is secured to the metal box shell 310 by the third screw 153, and the grounding mounting pin 113 and the sidewall of the metal box shell 310 clamp and fix the second end 142 of the grounding portion, thereby enabling the second end 142 of the grounding portion to be grounded. The assembling method of securing the grounding mounting pin 113 and the second end 142 of the grounding portion to the metal box shell 310 with the third screw 153 allows the second end 142 of the grounding portion to be quickly mounted onto the metal box shell 310, which is conducive to improving the assembly efficiency.

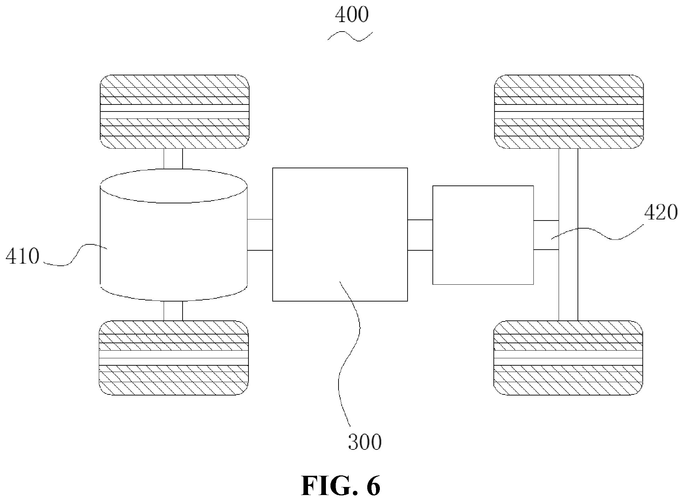

According to a fourth aspect of the present application, an electrical device 400 is designed and provided, as shown in FIG. 6. In this embodiment, the electrical device 400 includes an electrical load 410 and the battery 300 as described above. The battery 300 is electrically connected to the electrical load 410, and the battery 300 is configured to supply power to the electrical load 410.

The battery 300 prepared and produced may be, but not limited to, applied to a mobile phone, a tablet, a notebook, an electric toy, an electric tool, a battery vehicle, an electric vehicle, a ship, a spacecraft, and the like, so as to provide electric energy. The electric toy may be, but is not limited to, a fixed or mobile electric toy, such as a game machine, an electric vehicle toy, an electric ship toy, and an electric airplane toy. The spacecraft may include, but is not limited to, an aircraft, a rocket, a space shuttle, a spaceship, and the like.

In the embodiments of the present application, the electrical device 400 is an electric vehicle. As shown in FIG. 6, the battery 300 designed and provided by the embodiments of the present application supplies power to a drive motor of the electric vehicle. The drive motor is one of the electrical loads 410 on the electric vehicle, thereby enabling the electric vehicle to drive normally. In this embodiment, the battery 300 is mounted and fixed on a chassis 420 of the electric vehicle, and the drive motor is mounted on the chassis 420. The drive motor and the battery 300 are electrically connected by wiring on the chassis 420, and other electrical loads of the electric vehicle are electrically connected to the battery 300 by wiring, so that the battery 300 supplies power to the drive motor and other electrical loads on the electric vehicle.

The foregoing description illustrates merely preferred embodiments of the present application, but is not intended to limit the present application. Any modification, equivalent substitution, or improvement made within the spirit and principle of the present application shall fall within the protection scope of the present application.

## Claims

1. A shell structure for a high-voltage box, comprising:
an insulating shell provided with an inner cavity for mounting an electrical component, the insulating shell being provided with an assembling sidewall;
a connector mounted on an outer side of the assembling sidewall facing away from the inner cavity, wherein the connector is provided with a connection terminal and a shielding layer, the shielding layer surrounds the connection terminal, and the connection terminal passes through the assembling sidewall to the inner cavity and is configured to be electrically connected to the electrical component;
wherein the shell structure for a high-voltage box further comprises:
a metal plate mounted on the outer side of the assembling sidewall facing away from the inner cavity, wherein the metal plate is located between the connector and the assembling sidewall, the metal plate is provided with an assembling through hole, the connection terminal passes through the assembling through hole, and the shielding layer is electrically connected to the metal plate; and
a grounding portion, wherein a first end of the grounding portion is electrically connected to the metal plate and a second end of the grounding portion is configured for grounding.

2. The shell structure for a high-voltage box according to claim 1, wherein:
the shielding layer is inserted into the assembling through hole, and the shielding layer is in contact with a hole wall of the assembling through hole.

3. The shell structure for a high-voltage box according to claim 1 or 2, wherein:
the metal plate is pre-embedded in and fixed to the assembling sidewall.

4. The shell structure for a high-voltage box according to claim 1 or 2, wherein:
the metal plate is connected to the assembling sidewall by a screw.

5. The shell structure for a high-voltage box according to any one of claims 1 to 4, wherein:
the metal plate comprises a plate body and a connecting portion connected to each other, and the first end of the grounding portion is secured to the connecting portion by a screw;
or, the metal plate comprises a plate body and a connecting portion connected to each other, and the first end of the grounding portion is welded to the connecting portion.

6. The shell structure for a high-voltage box according to any one of claims 1 to 4, wherein:
the metal plate and the grounding portion are integrally formed.

7. The shell structure for a high-voltage box according to any one of claims 1 to 6, wherein:
the assembling sidewall is provided with a mounting groove, and the metal plate is mounted in the mounting groove.

8. The shell structure for a high-voltage box according to claim 7, wherein:
a groove depth of the mounting groove is less than or equal to a plate thickness of the metal plate.

9. The shell structure for a high-voltage box according to any one of claims 1 to 8, wherein:
the insulating shell is provided with a grounding mounting pin, the second end of the grounding portion extends to the grounding mounting pin, and the second end of the grounding portion is secured to the grounding mounting pin by a screw.

10. A high-voltage box, comprising an electrical component and the shell structure for a high-voltage box according to any one of claims 1 to 9, wherein the electrical component is mounted in the inner cavity of the insulating shell, and the electrical component is electrically connected to the connection terminal of the connector.

11. A battery, comprising the high-voltage box according to claim 10.

12. The battery according to claim 11, wherein the battery further comprises a metal box shell, the high-voltage box is arranged inside the metal box shell, the insulating shell is provided with a plurality of connecting pins, each of the connecting pins is connected to the metal box shell, and the second end of the grounding portion of the shell structure is arranged to be in contact with the metal box shell.

13. The battery according to claim 12, wherein:
the connecting pins are secured to the metal box shell by screws;
or, the metal box shell is provided with a plurality of locking structures, the plurality of locking structures are arranged in one-to-one correspondence to the connecting pins, and the connecting pins are secured to the metal box shell by the corresponding locking structures.

14. The battery according to claim 12, wherein:
the insulating shell is provided with a grounding mounting pin, the grounding mounting pin is secured to the metal box shell by a screw, and the grounding mounting pin and a side wall of the metal box shell clamp and fix the second end of the grounding portion.

15. An electrical device, comprising an electrical load and the battery according to any one of claims 11 to 14, wherein the battery is electrically connected to the electrical load and is configured to supply power.
